# EUROPÄISCHE PATENTSCHRIFT

(11) **EP 4 072 017 B1**
(45) Veröffentlichungstag und Bekanntmachung des Hinweises auf die Patenterteilung: **10.07.2024**
(21) Anmeldenummer: 22167126.6
(22) Anmeldetag: 07.04.2022
(51) Int. Cl.: H03K 17/96, E05B 81/76

(54) **SENSOREINRICHTUNG FÜR EIN KRAFTFAHRZEUG**
SENSOR DEVICE FOR A MOTOR VEHICLE
DISPOSITIF DÉTECTEUR POUR UN VÉHICULE AUTOMOBILE

(30) Priorität: 09.04.2021 DE 102021108849
(43) Veröffentlichungstag der Anmeldung: 12.10.2022
(73) Patentinhaber: Marquardt GmbH, 78604 Rietheim-Weilheim (DE)
(72) Erfinder: DOSTER, David, 78667 Villingendorf (DE); HALLAH, Kaci, 78532 Tuttlingen (DE); BOOS, Nadja, 78658 Zimmern ob Rottweil (DE)
(74) Vertreter: Staeger & Sperling Partnerschaftsgesellschaft mbB

(56) Entgegenhaltungen:
- WO-A1-2018/177580
- WO-A2-2005/008695
- US-A1- 2015 054 617

## Beschreibung

Die Erfindung betrifft eine Sensoreinrichtung für ein Kraftfahrzeug mit einer Sensorelektrode eines kapazitiven Sensors und einer Nahfeld-Übertragungsspule einer induktiven Nahfeld-Übertragungseinrichtung, einen Türgriff mit einer solchen Sensoreinrichtung sowie ein Kraftfahrzeug mit einem Türgriff oder einer solchen Sensoreinrichtung.

Sensoreinrichtungen mit integrierten kapazitiven Sensoren sind allgemein bekannt. Weiter ist auch deren Verwendung in Türgriffen und insbesondere Türaußengriffen von Kraftfahrzeugen bekannt, beispielsweise durch die Offenlegungsschrift DE 196 17 038 A1. Dabei dient der kapazitive Sensor dazu, eine Annäherung eines potentiellen Bedieners zu erfassen.

Der kapazitive Sensor umfasst dabei eine Sensorelektrode und eine Ansteuer- und Auswerteschaltung. Bei der Annäherung beispielsweise einer Hand des Bedieners wird die Kapazität der Sensorelektrode verändert, wobei diese Kapazitätsänderung durch die Ansteuer- und Auswerteschaltung erfasst und ausgewertet und mithin eine Annäherung erkannt wird.

Wird eine Annäherung erkannt, kann ein Aktor des Fahrzeugs geschalten, das Fahrzeug entriegelt oder eine Vorrichtung zur Fahrzeugentriegelung aktiviert werden, welche beispielsweise abhängig von einer weiteren Legitimierung bzw. einer weiteren Identifikation das Fahrzeug entriegeln kann.

Zur weiteren Identifikation kommen verschiedene Keyless-go-Systeme in Frage. Da Benutzer eines Kraftfahrzeugs meist möglichst wenige zusätzliche Geräte, wie einen Fahrzeugschlüssel, mitführen möchten, liegt es nahe, eine Identifikation durch ohnehin mitgeführte Geräte, wie ein Mobiltelefon, zu ermöglichen.

Zur Identifikation und Legitimationsprüfung des Benutzers kann daher eine Nahfeld-Übertragungseinrichtung vorgesehen sein, welche im Nahbereich die Kommunikation zwischen dem Fahrzeug und beispielsweise dem Mobiltelefon ermöglicht. Eine solche Nahfeld-Übertragungseinrichtung kann beispielsweise auf dem internationalen Near Field Communication (NFC) Übertragungsstandard basieren.

Ein Fahrzeugtürgriff mit sowohl einem kapazitiven Sensor als auch einer Nahfeld-Übertragungseinrichtung wird beispielsweise durch die WO 2014/146949 A1 beschrieben. Dort sind auf einer Leiterplatte eine Übertragungsspule einer Nahfeld-Übertragungseinrichtung und eine kapazitive Sensorelektrode des kapazitiven Sensors nebeneinander bzw. unabhängig voneinander angeordnet.

Problematisch dabei ist, dass der Bauraum in einem Türgriff begrenzt ist bzw. eine Sensoreinrichtung zur Reduzierung des notwendigen Bauraums platzsparend ausgebildet sein soll, was jedoch sowohl dem Funktionsprinzip eines kapazitiven Sensors als auch dem einer Nahfeld-Übertragungseinrichtung entgegenläuft, da diese umso empfindlicher ausgebildet werden können, je größer und entsprechend bauraumintensiver die jeweiligen Sensorelemente (Sensorelektrode und Nahfeld-Übertragungsspule) ausgebildet sind.

Entsprechend ist die von der WO 2014/146949 A1 vorgeschlagene Sensoreinrichtung vergleichsweise groß bzw. bauraumintensiv, da die Sensorelemente nebeneinander angeordnet sind.

Zur Lösung dieses Problems schlägt die DE 10 2018 103 047 A1 vor, die Sensorelektrode innerhalb der Nahfeld-Übertragungsspule anzuordnen, so dass also ein geringerer Platzbedarf bei zugleich großflächiger Ausbildung der Sensorelemente notwendig ist, da diese nicht mehr nebeneinander, sondern ineinander angeordnet sind.

Hierbei ist jedoch nachteilig, dass durch die Platzierung der Sensorelektrode innerhalb der als Antenne dienenden Nahfeld-Übertragungsspule die Feldstärke der Nahfeld-Übertragungsspule reduziert wird, da das elektrische Feld der Nahfeld-Übertragungsspule in die Sensorelektrode einkoppelt und dadurch eine der Feldstärke der Nahfeld-Übertragungsspule entgegenwirkende und diese dadurch reduzierende Gegeninduktivität erzeugt wird.

Weitere Sensoreinrichtungen oder zumindest Aspekte solcher Sensoreinrichtungen sind beispielsweise aus den Schriften WO 2018/177580 A1, WO 2005/008695 A2 und US 2015/054617 A1 bekannt.

Der Erfindung liegt deshalb die Aufgabe zugrunde, die vorgenannten Nachteile zu überwinden und eine Sensoreinrichtung mit einer Sensorelektrode eines kapazitiven Sensors und einer Nahfeld-Übertragungsspule einer induktiven Nahfeld-Übertragungseinrichtung bereitzustellen, welche platzsparend ausgebildet ist und bei welcher sich der kapazitive Sensor und die Nahfeld-Übertragungseinrichtung möglichst wenig stören bzw. gegenseitig beeinflussen.

Diese Aufgabe wird durch die Merkmalskombination gemäß Patentanspruch 1 gelöst.

Erfindungsgemäß wird daher eine Sensoreinrichtung für ein Kraftfahrzeug vorgeschlagen. Die Sensoreinrichtung weist ein Substrat auf, auf welchem flächig bzw. flach eine Sensorelektrode zumindest eines kapazitiven Sensors sowie eine Nahfeld-Übertragungsspule mit zumindest einer Windung zumindest einer induktiven Nahfeld-Übertragungseinrichtung angeordnet sind. Die Sensorelektrode wird zumindest abschnittsweise von der Nahfeld-Übertragungsspule umlaufen. Als zumindest abschnittsweise umlaufen wird vorliegend verstanden, dass sich die Nahfeld-Übertragungsspule über zumindest zwei, vorzugsweise drei und weiter vorzugsweise vier Seiten der Sensorelektrode auf dem Substrat erstreckt. Dabei ist erfindungsgemäß vorgesehen, dass die Sensorelektrode eine Vielzahl von geradlinig verlaufenden und miteinander verbundenen Sensorabschnitten sowie zumindest einen vorzugsweise geradlinig verlaufendem Verbindungsabschnitt aufweist und weiter vorzugsweise durch diese gebildet wird. Die Sensorabschnitte der Vielzahl von Sensorabschnitten sind dabei in Gruppen unterteilt bzw. gegliedert, deren Sensorabschnitte in Reihe und unmittelbar miteinander verbunden sind, so dass jeweils ein erster Sensorabschnitt einer Gruppe unmittelbar in einen direkt nachfolgenden zweiten Sensorabschnitt der Gruppe übergeht. Der jeweils erste Sensorabschnitt und der jeweils zweite Sensorabschnitt schließen dabei einen Winkel zwischen sich ein. Der erste Sensorabschnitt und der zweite Sensorabschnitt sind also nicht parallel oder entlang einer gemeinsamen Achse ausgebildet und entsprechend schräg zueinander. Weiter sind jeweils zwei Gruppen von Sensorabschnitten durch jeweils einen Verbindungsabschnitt signaltechnisch in Reihe miteinander verbunden.

Durch den erfindungsgemäß vorgeschlagenen Aufbau der Sensoreinrichtung ist die durch die Sensorelektrode gebildete Sensorfläche des kapazitiven Sensors platzsparend an bzw. innerhalb der Nahfeld-Übertragungsspule der induktiven Nahfeld-Übertragungseinrichtung angeordnet, so dass die Sensoreinrichtung äußerst bauraumsparend ausgebildet werden kann, wobei durch den vorgeschlagenen Aufbau der Sensorelektrode bzw. durch die vorgeschlagene Anordnung der Sensorabschnitte der Sensorelektrode erreicht wird, dass in diese durch die Nahfeld-Übertragungsspule keine oder nur eine sehr geringe Gegeninduktivität erzeugt wird, welche entsprechend die Feldstärke der Nahfeld-Übertragungsspule nicht oder nur geringfügig reduziert.

Vorzugsweise ist durch den vorgeschlagenen Aufbau der Sensorelektrode bzw. durch die vorgeschlagene Anordnung der Sensorabschnitte der Sensorelektrode vorgesehen, dass die Sensorabschnitte soweit möglich nicht parallel zu der Nahfeld-Übertragungsspule bzw. zu wesentlichen Abschnitten (Spulenabschnitten) der Nahfeld-Übertragungsspule verlaufen. Die wesentlichen Abschnitte sind dabei vorzugsweise längsseitige Spulenabschnitte, welche von zumindest einem stirnseitigen Spulenabschnitt verbunden werden, wobei die längsseitigen Spulenabschnitte länger sind als die stirnseitigen Spulenabschnitte.

Neben dem sich dadurch ergebenden platz- bzw. bauraumminimierenden Aufbau, bei zugleich keiner oder nur geringer Störung des elektrischen Feldes der Nahfeld-Übertragungsspule durch Gegeninduktion in der Sensorelektrode, kommt als weiterer Vorteil der erfindungsgemäßen Sensoreinrichtung hinzu, dass für den Benutzer lediglich ein Bereich der Sensoreinrichtung relevant ist, in welchem sowohl die Nahfeld-Übertragungsspule als auch die Sensorelektrode angeordnet ist, so dass sich der Benutzer nicht merken muss, in welchem Bereich die Hand und in welchem Bereich ein Identifikator (z.B. Mobiltelefon) an die Sensoreinrichtung angenähert werden muss.

Soweit technisch nicht vermeidbar, sollte ein Leiter bzw. eine Leiterbahn, aus welchem die Sensorelektrode gebildet ist, bzw. die Sensorabschnitte nur sehr geringe oder vorzugsweise keine parallel zu der Nahfeld-Übertragungsspule bzw. zu den Spulenabschnitten verlaufenden Anteile aufweisen. Sind parallel verlaufende Anteile technisch nicht vermeidbar, sollten diese möglichst kurz sein und sich nicht über die gesamte Länge der Nahfeld-Übertragungsspule erstrecken. Vorteilhaft ist beispielsweise, wenn solche parallelen Anteile des Leiters bzw. der Leiterbahn bzw. eines Sensorabschnitts maximal 1/5 und weiter vorzugsweise maximal 1/10 der Länge der Nahfeld-Übertragungsspule oder der Spulenabschnitte lang sind. Weiter sollten solche parallelen Anteile zur Reduktion der Induktion mit einem maximal möglichen Abstand von der Nahfeld-Übertragungsspule bzw. den Spulenabschnitten und mithin in einer Mitte bzw. an oder entlang einer Mittellinie der Nahfeld-Übertragungsspule angeordnet sein.

Weiter können die Sensorabschnitte der Vielzahl von Sensorabschnitte gleich oder unterschiedlich lang sein, wobei die Winkel zwischen den Sensorabschnitten ebenfalls gleich oder unterschiedlich sein können.

Die Gruppen von Sensorabschnitten können gleichviele Sensorabschnitte oder unterschiedlich viele Sensorabschnitte umfassen. Dabei können auch die Verbindungsabschnitte, welche die Gruppen verbinden, gleich oder unterschiedlich lang sein.

Eine vorteilhafte Weiterbildung der Sensoreinrichtung sieht zudem vor, dass die Nahfeld-Übertragungsspule zumindest einen im Wesentlichen geradlinigen Spulenabschnitt aufweist, wobei die Sensorabschnitte in einer gedachten Verlängerung den zumindest einen Spulenabschnitt oder eine gedachte Verlängerung des zumindest einen Spulenabschnitts schneiden. Wie bereits beschrieben kann die Nahfeld-Übertragungsspule als Spulenabschnitte längsseitige und stirnseitige Spulenabschnitte aufweisen, wobei die Sensorabschnitte in ihrer gedachten Verlängerung vorzugsweise die längsseitigen Spulenabschnitte bzw. deren gedachte Verlängerung schneiden.

Vorteilhaft kann hierbei ferner vorgesehen sein, dass die Nahfeld-Übertragungsspule miteinander verbundene und zueinander im Wesentlichen rechtwinklige Spulenabschnitte aufweist oder durch diese gebildet ist, welche gemeinsam einen im Wesentlichen rechteckigen Bereich des Substrats abgrenzen, innerhalb welchem vorzugsweise die Sensorelektrode angeordnet ist.

Ferner ist eine Variante der Sensoreinrichtung von Vorteil, bei welcher der zumindest eine Verbindungsabschnitt oder - falls mehrere bzw. eine Vielzahl von Verbindungsabschnitten vorgesehen sind - zumindest einer der Verbindungsabschnitte in einer gedachten Verlängerung den zumindest einen Spulenabschnitt oder eine gedachte Verlängerung des zumindest einen Spulenabschnitts schneidet, wobei es sich bei dem Spulenabschnitt vorzugsweise um einen längsseitigen Spulenabschnitt handelt.

Alternativ kann der zumindest eine Verbindungsabschnitt oder - falls mehrere bzw. eine Vielzahl von Verbindungsabschnitten vorgesehen sind - zumindest einer der Verbindungsabschnitte auch parallel zu dem zumindest einen Spulenabschnitt verlaufen, wobei der oder die Verbindungsabschnitte zur Reduzierung der Induktion im Vergleich zu dem Spulenabschnitt möglichst kurz und vorzugsweise maximal 1/5 und weiter vorzugsweise maximal 1/10 der Länge des Spulenabschnitts lang sein sollte(n).

Von Vorteil ist zudem eine Ausführungsvariante der Sensoreinrichtung, bei welcher die Nahfeld-Übertragungsspule im Wesentlichen symmetrisch ausgebildet und durch eine gedachte Mittellinie im Wesentlichen symmetrisch teilbar ist. Dabei ist vorgesehen, dass der zumindest eine Verbindungsabschnitt oder - falls mehrere bzw. eine Vielzahl von Verbindungsabschnitten vorgesehen sind - zumindest einer der Verbindungsabschnitte auf der Mittellinie verläuft oder die Mittellinie schneidet oder näher an der Mittellinie verläuft als an der Nahfeld-Übertragungsspule, so dass also der Verbindungsabschnitt bzw. die Verbindungsabschnitte einen größtmöglichen Abstand zu der Nahfeld-Übertragungsspule aufweisen und eine Gegeninduktion entsprechend gering ist.

Zur Bauraumreduzierung und Platzersparnis ist eine Weiterbildung vorteilhaft, bei welcher die Sensorelektrode vollständig in einem von der Nahfeld-Übertragungsspule abgegrenzten Bereich des Substrats angeordnet ist, bei welchem es sich um den genannten rechteckigen Bereich handeln kann.

Vorzugsweise ist das Substrat eine starre oder flexible Leiterplatte.

Weiter ist von Vorteil, wenn die Sensorelektrode und/oder die Nahfeld-Übertragungsspule zumindest abschnittsweise und insbesondere vollständig durch auf dem Substrat ausgebildete Leiterbahnen gebildet werden/wird, so dass also die Sensorelektrode und/oder die Nahfeld-Übertragungsspule als Leiterbahnstruktur bezeichnet werden kann.

Gemäß einer weiteren vorteilhaften Variante weist die Sensoreinrichtung ferner eine Steuerelektronik auf, welche signaltechnisch mit der Sensorelektrode und/oder mit der Nahfeld-Übertragungsspule verbunden ist. Die Sensorelektrode und/oder die Nahfeld-Übertragungsspule können unmittelbar oder beispielsweise über eine Anschlussleitung, welche ebenfalls als Leiterbahn ausgebildet sein kann, mit der Steuerelektronik signaltechnisch verbunden sein. Vorzugsweise wird durch die Steuerelektronik eine Ansteuer- und Auswerteschaltung zur Ansteuerung und Auswertung der Sensorelektrode und/oder der Nahfeld-Übertragungsspule implementiert, so dass die Sensorelektrode mit der Steuerelektronik den kapazitiven Sensor und/oder die Nahfeld-Übertragungsspule mit der Steuerelektronik die induktiven Nahfeld-Übertragungseinrichtung bilden/bildet.

Die Steuerelektronik kann auf dem Substrat angeordnet sein. Dabei kann die Steuerelektronik auf einer Seite bzw. Fläche des Substrats angeordnet sein, auf welcher auch die Sensorelektrode und/oder die Nahfeld-Übertragungsspule angeordnet sind/ist. Alternativ kann die Steuerelektronik auch auf einer gegenüberliegenden Seite bzw. Fläche des Substrats angeordnet sein, wobei diese dann über eine Kante des Substrats oder durch das Substrat hindurch signaltechnisch mit der Sensorelektrode und/oder der Nahfeld-Übertragungsspule verbunden sein kann.

Ein weiterer Aspekt der Erfindung betrifft einen Türgriff für ein Kraftfahrzeug mit einer erfindungsgemäßen Sensoreinrichtung.

Ferner betrifft ein Aspekt der Erfindung ein Kraftfahrzeug mit einer erfindungsgemäßen Sensoreinrichtung und/oder einem erfindungsgemäßen Türgriff.

Die vorstehend offenbarten Merkmale sind beliebig kombinierbar, soweit dies technisch möglich ist und diese nicht im Widerspruch zueinander stehen.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt. Es zeigen:
- Fig. 1: eine Sensoreinrichtung;
- Fig. 2: eine Sensoreinrichtung mit Steuerelektronik;
- Fig. 3: eine weitere Variante einer Sensoreinrichtung.

Die Figuren sind beispielhaft schematisch. Gleiche Bezugszeichen in den Figuren weisen auf gleiche funktionale und/oder strukturelle Merkmale hin.

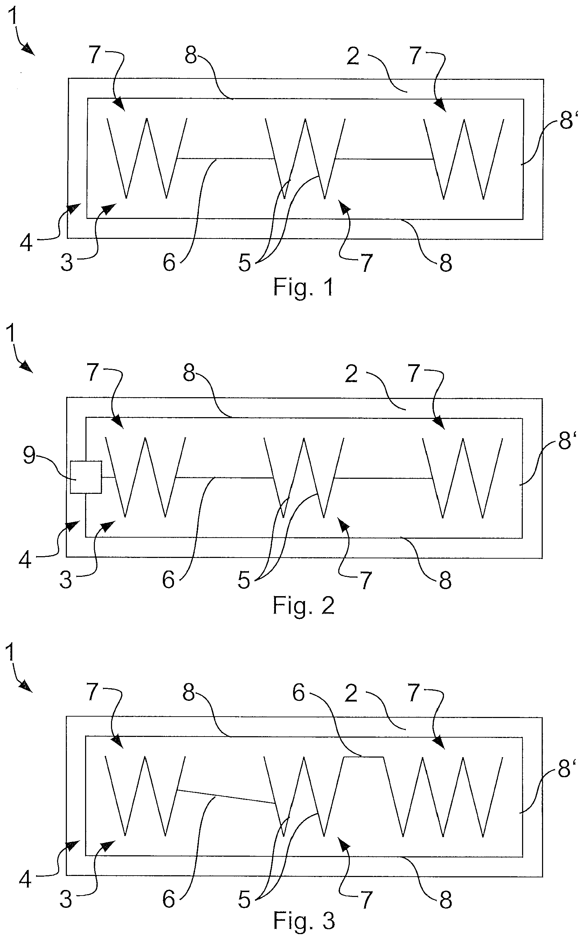

Figur 1 zeigt eine Sensoreinrichtung 1, welche ein Substrat 2 umfasst, auf welchem flächig eine Sensorelektrode 3 zumindest eines kapazitiven Sensors sowie eine Nahfeld-Übertragungsspule 4 mit zumindest einer Windung zumindest einer induktiven Nahfeld-Übertragungseinrichtung angeordnet sind.

Bei dem Substrat 2 handelt es sich vorliegend um eine Leiterplatte, wobei die Sensorelektrode 3 und die Nahfeld-Übertragungsspule 4 auf der Leiterplatte ausgebildete und beispielsweise geätzte oder gedruckte Leiterbahnen sind.

Um einen platzsparenden Aufbau der Sensoreinrichtung 1 zu ermöglichen, ist die Sensorelektrode 3 bzw. die Sensorabschnitte 5, welche die Sensorelektrode 3 zusammen mit den Verbindungsabschnitten 6 bilden, vollständig innerhalb der Nahfeld-Übertragungsspule 4 bzw. innerhalb eines von der Nahfeld-Übertragungsspule 4 abgegrenzten Bereichs angeordnet.

Die Nahfeld-Übertragungsspule 4 wird dabei von den zwei einander gegenüberliegenden längsseitigen Spulenabschnitten 8 und zwei weiteren stirnseitigen Spulenabschnitten 8` gebildet, wobei die stirnseitigen Spulenabschnitte 8` kürzer sind als die längsseitigen Spulenabschnitte 8, so dass die Spule bzw. das durch die Spule induzierte elektrische Feld im Wesentlichen durch die längsseitigen Spulenabschnitte 8 bestimmt wird.

Um zugleich eine Einkopplung des von der Nahfeld-Übertragungsspule 4 erzeugten elektromagnetischen Feldes in die Sensorelektrode 3 zu minimieren, so dass es auch lediglich zu einer minimalen Gegeninduktion und einer damit verbundenen minimierten Schwächung des elektromagnetischen Feldes kommt, sind die Sensorabschnitte 5 schräg zu den längsseitigen Spulenabschnitten 8 und zu den stirnseitigen Spulenabschnitte 8' der Nahfeld-Übertragungsspule 4 bzw. diese in einer gedachten Verlängerung schneidend angeordnet.

Die Vielzahl von Sensorabschnitten 5 sind in Gruppen 7 von Sensorabschnitten 5 und vorliegend in drei Gruppen 7 unterteilt, wobei jeweils zwei Gruppen 7 von einem Verbindungsabschnitt 6 signaltechnisch verbunden werden, so dass also alle und hier alle drei Gruppen 7 in Reihe miteinander verbunden sind.

Die Verbindungsabschnitte 6 bzw. vorliegend die zwei Verbindungsabschnitte 6 verlaufen entlang einer gedachten Mittellinie der Nahfeld-Übertragungsspule 4, so dass sie einen maximalen Abstand von den beiden längsseitigen Spulenabschnitten 8 aufweisen, welche die Nahfeld-Übertragungsspule 4 im Wesentlichen bestimmen.

Figur 2 zeigt eine Sensoreinrichtung gemäß Figur 1, wobei ferner eine Steuerelektronik 9 auf dem Substrat 2 angeordnet ist, mit welcher sowohl die Sensorelektrode 3 als auch die Nahfeld-Übertragungsspule 4 verbunden ist.

Die Ausführungsform gemäß Figur 3 ist eine Abwandlung der in Figur 1 dargestellten Variante, wobei gezeigt ist, dass die Gruppen 7 von Sensorabschnitten 5 nicht gleiche viele Sensorabschnitte 5 umfassen müssen, sondern auch unterschiedlich viele Sensorabschnitte 5 gruppieren können. Ferner muss ein zwei Gruppen 7 verbindender Verbindungsabschnitt 6 nicht entlang der Mittellinie und/oder parallel zu dieser angeordnet sein, sondern kann auch beispielsweise schräg zu der Mittellinie oder außermittig verlaufen. Die Anordnung und der Verlauf der Verbindungsabschnitte 6 kann dabei derart gewählt werden, dass es zu einer minimalen Gegeninduktion kommt.

## Patentansprüche

1. Sensoreinrichtung (1) für ein Kraftfahrzeug,
aufweisend ein Substrat (2), auf welchem flächig eine Sensorelektrode (3) zumindest eines kapazitiven Sensors sowie eine Nahfeld-Übertragungsspule (4) mit zumindest einer Windung zumindest einer induktiven Nahfeld-Übertragungseinrichtung angeordnet sind,
wobei die Sensorelektrode (3) zumindest abschnittsweise von der Nahfeld-Übertragungsspule (4) umlaufen wird,
wobei die Sensorelektrode (3) eine Vielzahl von geradlinig verlaufenden und miteinander verbundenen Sensorabschnitten (5) sowie zumindest einen Verbindungsabschnitt (6) aufweist,
**dadurch gekennzeichnet, dass**
die Sensorabschnitte (5) der Vielzahl von Sensorabschnitten (5) in Gruppen (7) unterteilt sind, deren Sensorabschnitte (5) in Reihe und unmittelbar miteinander verbunden sind, so dass jeweils ein erster Sensorabschnitt einer Gruppe unmittelbar in einen direkt nachfolgenden zweiten Sensorabschnitt der Gruppe übergeht,
wobei der erste Sensorabschnitt und der zweite Sensorabschnitt einen Winkel zwischen sich einschließen,
wobei jeweils zwei Gruppen (7) von Sensorabschnitten durch jeweils einen Verbindungsabschnitt (6) signaltechnisch in Reihe miteinander verbunden sind.

2. Sensoreinrichtung nach Anspruch 1,
wobei die Nahfeld-Übertragungsspule (4) zumindest einen im Wesentlichen geradlinigen Spulenabschnitt (8, 8') aufweist,
und wobei die Sensorabschnitte (5) in einer gedachten Verlängerung den zumindest einen Spulenabschnitt (8, 8') oder eine gedachte Verlängerung des zumindest einen Spulenabschnitts (8, 8') schneiden.

3. Sensoreinrichtung nach Anspruch 2,
wobei die Nahfeld-Übertragungsspule (4) miteinander verbundene und zueinander im Wesentlichen rechtwinklige Spulenabschnitte (8, 8') aufweist, welche gemeinsam einen im Wesentlichen rechteckigen Bereich des Substrats (2) abgrenzen.

4. Sensoreinrichtung nach einem der Ansprüche 2 oder 3,
wobei der zumindest eine Verbindungsabschnitt (6) in einer gedachten Verlängerung den zumindest einen Spulenabschnitt (8, 8') oder eine gedachte Verlängerung des zumindest einen Spulenabschnitts (8, 8') schneidet.

5. Sensoreinrichtung nach einem der vorhergehenden Ansprüche,
wobei die Nahfeld-Übertragungsspule (4) im Wesentlichen symmetrisch ausgebildet und durch eine gedachte Mittellinie im Wesentlichen symmetrisch teilbar ist,
wobei der zumindest eine Verbindungsabschnitt (6) auf der Mittellinie verläuft oder die Mittellinie schneidet oder näher an der Mittellinie verläuft als an der Nahfeld-Übertragungsspule (4).

6. Sensoreinrichtung nach einem der vorhergehenden Ansprüche,
wobei die Sensorelektrode (3) vollständig in einem von der Nahfeld-Übertragungsspule (4) abgegrenzten Bereich des Substrats (2) angeordnet ist.

7. Sensoreinrichtung nach einem der vorhergehenden Ansprüche,
wobei die Sensorelektrode (3) und/oder die Nahfeld-Übertragungsspule (4) zumindest abschnittsweise und insbesondere vollständig durch auf dem Substrat (2) ausgebildete Leiterbahnen gebildet werden/wird.

8. Sensoreinrichtung nach einem der vorhergehenden Ansprüche,
ferner aufweisend eine Steuerelektronik (9), welche signaltechnisch mit der Sensorelektrode (3) und/oder mit der Nahfeld-Übertragungsspule (4) verbunden ist.

9. Türgriff für ein Kraftfahrzeug mit einer Sensoreinrichtung (1) gemäß einem der vorhergehenden Ansprüche.

10. Kraftfahrzeug mit einer Sensoreinrichtung (1) gemäß einem der vorhergehenden Ansprüche 1 bis 8 und/oder einem Türgriff gemäß dem vorhergehenden Anspruch.

## Claims

1. A sensor device (1) for a motor vehicle,
having a substrate (2) on which a sensor electrode (3) of at least one capacitive sensor and a near-field transmission coil (4) with at least one winding of at least one inductive near-field transmission device are arranged in a planar manner,
wherein the sensor electrode (3) is at least partially surrounded by the near-field transmission coil (4),
wherein the sensor electrode (3) has a plurality of sensor sections (5) extending linearly and connected to one another, and at least one connecting section (6),
**characterized in that** the sensor sections (5) of the plurality of sensor sections (5) are divided into groups (7), the sensor sections (5) of which are connected in series and directly to one another such that a first sensor section of each group directly transitions into an immediately following second sensor section of the group,
wherein the first sensor section and the second sensor section enclose an angle between one another,
wherein two respective groups (7) of sensor sections are signally connected in series to one another by a respective connecting section (6).

2. The sensor device according to claim 1,
wherein the near-field transmission coil (4) has at least one substantially linear coil section (8, 8'),
and wherein the sensor sections (5) intersect with the at least one coil section (8, 8') or an imaginary extension of the at least one coil section (8, 8') in an imaginary extension.

3. The sensor device according to claim 2,
wherein the near-field transmission coil (4) has coil sections (8, 8') which are connected to one another and are substantially orthogonal to one another and which together delimit a substantially rectangular area of the substrate (2).

4. The sensor device according to any one of claims 2 or 3,
wherein the at least one connecting section (6) intersects with the at least one coil section (8, 8') or an imaginary extension of the at least one coil section (8, 8') in an imaginary extension.

5. The sensor device according to any one of the preceding claims,
wherein the near-field transmission coil (4) is formed substantially symmetrically and is substantially symmetrically divisible by an imaginary centerline,
wherein the at least one connecting section (6) extends on the centerline or intersects with the centerline or extends closer to the centerline than to the near-field transmission coil (4).

6. The sensor device according to any one of the preceding claims,
wherein the sensor electrode (3) is completely disposed in an area of the substrate (2) delimited by the near-field transmission coil (4).

7. The sensor device according to any one of the preceding claims,
wherein the sensor electrode (3) and/or the near-field transmission coil (4) is/are at least partially and in particular completely formed by conductive tracks configured on the substrate (2).

8. The sensor device according to any one of the preceding claims,
further having control electronics (9) signally connected to the sensor electrode (3) and/or to the near-field transmission coil (4).

9. A door handle for a motor vehicle with a sensor device (1) according to any one of the preceding claims.

10. A motor vehicle with a sensor device (1) according to any one of claims 1 to 8 and/or a door handle according to the preceding claim.

## Revendications

1. Dispositif capteur (1) pour un véhicule automobile,
présentant un substrat (2) sur lequel sont disposés de manière plane une électrode de capteur (3) d'au moins un capteur capacitif ainsi qu'une bobine de transmission en champ proche (4) pourvue d'au moins un enroulement d'au moins un dispositif de transmission en champ proche par induction,
dans lequel l'électrode de capteur (3) est au moins par endroits encerclée par la bobine de transmission en champ proche (4),
dans lequel l'électrode de capteur (3) présente une pluralité de sections de capteur (5) reliées les unes aux autres et s'étendant en ligne droite, ainsi qu'au moins une section de liaison (6),
**caractérisé en ce que** les sections de capteur (5) de la pluralité de sections de capteur (5) sont divisées en groupes (7) dont les sections de capteur sont reliées en série et directement les unes aux autres de sorte que respectivement une première section de capteur d'un groupe passe directement à une deuxième section de capteur immédiatement suivante,
dans lequel la première section de capteur et la deuxième section de capteur forment un angle entre elles,
dans lequel respectivement deux groupes (7) de sections de capteur sont reliées en série l'un à l'autre par respectivement une section de liaison (6) pour la transmission de signaux.

2. Dispositif capteur selon la revendication 1,
dans lequel la bobine de transmission en champ proche (4) présente au moins une section de bobine (8, 8') substantiellement rectiligne,
et dans lequel les sections de capteur (5) intersectent dans un prolongement imaginaire ladite au moins une section de bobine (8, 8') ou un prolongement imaginaire de ladite au moins une section de bobine (8, 8').

3. Dispositif capteur selon la revendication 2,
dans lequel la bobine de transmission en champ proche (4) présente des sections de bobine (8, 8') reliées l'une à l'autre et substantiellement perpendiculaires l'une à l'autre qui délimitent ensemble une zone substantiellement rectangulaire du substrat (2).

4. Dispositif capteur selon l'une quelconque des revendications 2 ou 3,
dans lequel ladite au moins une section de liaison (6) intersecte dans un prolongement imaginaire ladite au moins une section de bobine (8, 8') ou un prolongement imaginaire de ladite au moins une section de bobine (8, 8').

5. Dispositif capteur selon l'une quelconque des revendications précédentes,
dans lequel la bobine de transmission en champ proche (4) est réalisée de manière substantiellement symétrique et peut être divisée de manière substantiellement symétrique par une ligne médiane imaginaire,
dans lequel ladite au moins une section de liaison (6) s'étend sur la ligne médiane ou intersecte la ligne médiane ou s'étend plus près de la ligne médiane que de la bobine de transmission en champ proche (4).

6. Dispositif capteur selon l'une quelconque des revendications précédentes,
dans lequel l'électrode de capteur (3) est entièrement disposée dans une zone du substrat (2) délimitée par la bobine de transmission en champ proche (4).

7. Dispositif capteur selon l'une quelconque des revendications précédentes,
dans lequel l'électrode de capteur (3) et/ou la bobine de transmission en champ proche (4) sont formées au moins par endroits et en particulier entièrement par des pistes conductrices réalisées sur le substrat (2).

8. Dispositif capteur selon l'une quelconque des revendications précédentes,
présentant en outre une électronique de commande (9) qui est reliée à l'électrode de capteur (3) et/ou à la bobine de transmission en champ proche (4) pour la transmission de signaux.

9. Poignée de portière pour un véhicule automobile, comprenant un dispositif capteur (1) selon l'une quelconque des revendications précédentes.

10. Véhicule automobile, comprenant un dispositif capteur (1) selon l'une quelconque des revendications précédentes 1 à 8 et/ou une poignée de portière selon la revendication précédente.
